(19) 

**Europäisches Patentamt**
**European Patent Office**
**Office européen des brevets**

(11) **EP 1 913 210 B1**

(12) **EUROPÄISCHE PATENTSCHRIFT**

(45) Veröffentlichungstag und Bekanntmachung des Hinweises auf die Patenterteilung:
**18.01.2012 Patentblatt 2012/03**

(21) Anmeldenummer: **06762963.4**

(22) Anmeldetag: **03.08.2006**

(51) Int Cl.:
*E04B 1/92* (2006.01)          *H05K 9/00* (2006.01)
*H02G 13/00* (2006.01)

(86) Internationale Anmeldenummer:
**PCT/EP2006/007689**

(87) Internationale Veröffentlichungsnummer:
**WO 2007/017178 (15.02.2007 Gazette 2007/07)**

(54) **SYSTEM ZUM ABLEITEN VON BLITZSTRÖMEN UND/ODER VON FEHLSTRÖMEN**

SYSTEM FOR CONDUCTING AWAY LIGHTNING CURRENTS AND/OR FAULT CURRENTS

SYSTEME POUR DEVIER DES COURANTS DE FOUDRE ET/OU DES COURANTS DE FUITE

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **05.08.2005 DE 102005037670**
**12.10.2005 DE 102005049306**

(43) Veröffentlichungstag der Anmeldung:
**23.04.2008 Patentblatt 2008/17**

(73) Patentinhaber: **EWALD DÖRKEN AG**
**58313 Herdecke (DE)**

(72) Erfinder:
• **SCHRÖER, Jörn**
**58313 Herdecke (DE)**

• **SCHWAAB, Gilles**
**44225 Dortmund (DE)**
• **RAIDT, Heinz, Peter**
**44227 Dortmund (DE)**

(74) Vertreter: **Gesthuysen, von Rohr & Eggert**
**Patentanwälte**
**Postfach 10 13 54**
**45013 Essen (DE)**

(56) Entgegenhaltungen:
**DE-A1- 1 557 383       DE-U1- 20 015 514**
**DE-U1- 20 315 042       US-A- 443 048**
**US-A1- 2003 033 755**

**Beschreibung**

Die Erfindung betrifft ein System nach dem Oberbegriff des Anspruchs 1.

Bei dem Neubau, der Sanierung, der Umdekkung und dem nachträglichen Ausbau eines Daches werden Unterspann- oder Unterdeckschalungsbahnen, Wasser- und/oder Dampf- und/oder Luftsperren oder Fassadenbahnen eingesetzt. Neben den üblichen Funktionen, die solche Bahnen zu erfüllen haben, wie beispielsweise Wärmedämmung, Schalldämmung, Feuchtigkeitsschutz, wird durch eine leitfähige Bahn insbesondere eine elektromagnetische Abschirmung im MHz- bzw. GHz-Bereich ermöglicht.

Bei einer leitfähigen Bahn der vorgenannten Art kann es sich um eine Bahn handeln, die eine Metallschicht aufweist. Metallbeschichtete Bahnen sind als metallkaschierte oder metallbedampfte Bahnen bekannt. Darüber hinaus ist es möglich, dass die elektrisch leitende Schicht der Bahn Kohlenstoffpartikel oder -fasern, insbesondere Ruß und/oder Graphit und/oder eine elektrisch leitende Graphitverbindung aufweist. Die elektrisch leitende Komponente der Schicht kann auch mit einem Bindemittel vermischt sein. Die Bahn als solche kann ein- oder mehrschichtig ausgebildet sein. Beispielsweise kann es sich bei der Bahn um eine dünne Metallfolie handeln, die direkt auf einen Untergrund im Dach- und/oder Fassadenbereich aufgebracht wird. Vorzugsweise weist die Bahn jedoch weitere Schichten auf, beispielsweise Schutz- und/oder Verstärkungs- und/oder Funktionsschichten. Die Bahn kann wasserdicht und wasserdampfdurchlässig sowie witterungsbeständig sein.

Leitfähige Bahnen sind bereits aus dem Stand der Technik bekannt. So ist in der DE 103 37 792 A1 eine eine Reflektionsschicht aufweisende Bahn beschrieben, die wasserdicht, wasserdampfdurchlässig und witterungsbeständig ausgebildet sein kann. Durch die Reflektionsschicht wird elektromagnetische Strahlung bei der bekannten Bahn gedämpft. Darüber hinaus ist bekannt, durch Anlegen eines Potentialausgleichs an der Reflexionsschicht die Abstrahlung elektromagnetischer Strahlung in den abzuschirmenden Raum durch die Reflexionsschicht selbst zu verhindern. Durch den Potentialausgleich wird die Reflexionsschicht spannungsfrei gestaltet, so dass die Reflexionsschicht selbst nicht nach Art einer Antenne elektromagnetische Strahlung bzw. elektromagnetische Felder an den abzuschirmenden Raum weiterleiten kann.

Von Nachteil bei der bekannten Bahn ist, dass der an die Reflexionsschicht angelegte Potentialausgleich dafür ausgelegt ist, die Abstrahlung elektromagnetischer Strahlung von der Reflexionsschicht selbst in den abzuschirmenden Raum zu verhindern, wobei die Reflexionsschicht nur gering geladen ist. Das Anlegen des Potentialausgleichs verhindert, dass die Reflexionsschicht elektromagnetische Strahlung absorbiert und diese dann zum abzuschirmenden Raum hin abgibt.

Kommt es jedoch zu einem Blitzeinschlag und zu einem Einkoppeln von Blitzstrom auf die leitfähige Reflexionsschicht, so führt dies zu einer Zerstörung des Potentialausgleichs. Dies hat zur Folge, dass die leitfähige Reflexionsschicht unter Spannung steht und somit eine Gefahr für Personen darstellt, die sich im Dach- oder Fassadenbereich in unmittelbarer Nähe zu der Reflexionsschicht aufhalten.

Darüber hinaus stellen untereinander verbundene leitfähige Bahnen eine große elektrisch leitfähige Fläche dar, die in unmittelbaren Kontakt mit elektrischen Einrichtungen und Leitungen kommen kann bzw. durch die elektrische Leitungen hindurchgeführt werden müssen. Bei Fehlern in der Elektroinstallation kann deshalb nicht ausgeschlossen werden, dass die leitfähige Reflexionsschicht ebenfalls unter Spannung steht. Damit ist eine großflächige Personengefährdung im gesamten Dach- und/oder Fassadenbereich verbunden und die Gefahr der Bildung von elektrischen Funken. Kommt es bei Fehlern in der Elektroinstallation dazu, dass die leitfähige Reflexionsschicht unter Spannung steht, kann dies bei der bekannten, eine Reflexionsschicht aufweisenden Bahn dazu führen, dass der Potentialausgleich zerstört wird und ein Spannungsabbau nicht stattfindet. Die Personengefährdung und die Gefahr der Bildung von elektrischen Funken bleiben somit bestehen.

Aus der DE-U-203 15 042 ist eine Außenverkleidung von Dachflächen bekannt. Die Dachflächenaußenverkleidung ist dabei auf der der Sonne zu gewandten Seite von Dachflächen oder auf Teilen dieser Fläche als dünne elektromagnetische Wellen reflektierende Schicht mit hoher elektrischer spezifischer Leitfähigkeit aufgebracht. Bei der Schicht kann es sich um eine Aluminium- oder Staniolschicht handeln, die aufgeklebt, angerieben oder aufvulkanisiert sein kann.

Aus der US-A-2003/0033755 geht eine Gewitter- oder Blitzschutzhütte auf Golfplätzen hervor. Die Schutzhütte weist außenseitig eine metallische Schicht oder aber ein außenseitiges metallisches Gitter zur Ableitung von Blitzströmen und/oder Fehlströmen auf.

Die DE-A-1 557 383 betrifft ein Zelt, dass als Faradayscher Käfig ausgebildet ist, wobei die Zeltbespannung elektrisch leitend ist oder eingewebte bzw. aufgenähte Nähte Metalldrähte oder -litzen, aufgelegte Metallfolien oder dergleichen besitzt.

Aus der US-A-443,048 geht eine Einrichtung zum Blitzschutz hervor, bei der auf dem Dach eine Art Antenne vorgesehen ist, die mit einer dünnen Metallschicht verbunden ist, die das Dach bedeckt.

Aufgabe der vorliegenden Erfindung ist es, ein System der eingangs genannten Art zur Verfügung zu stellen, mit dem es möglich ist, elektromagnetische Strahlung vom Dach- und/oder Fassadenbereich eines Gebäudes abzuschirmen und Blitzströme und/oder Fehlströme aus dem Dach- und/oder Fassadenbereich sicher abzuleiten.

Die vorgenannte Aufgabe ist bei einem System der eingangs genannten Art durch die Merkmale des Anspruchs 1 gelöst. Der Erfindung liegt der Grundgedanke zugrunde, eine elektrisch leitende Bahn, beispielsweise eine Unterspannbahn im Dachbereich, als sogenanntes fremdes, leitfähiges Teil zu behandeln und in den Potentialausgleich des Gebäudes einzubinden, Dazu ist es erfindungsgemäß vorgesehen, dass die Bahn zur Erdung mit dem Gebäudepotentialausgleich bzw. einer Potentialausgleichsleitung verbunden wird, um im Falle eines Blitzeinschlags oder bei Fehlern in der Elektroinstallation die auftretenden Blitzströme und/oder Fehlströme über die Bahn und den Gebäudepotentialausgleich in den Boden ableiten zu können. Dies setzt eine ausreichende Dimensionierung der Potentialausgleichsleitung voraus, damit es im Falle eines Blitzeinschlags und/oder bei Fehlern in der Elektroinstallation nicht zu einer Zerstörung der Potentialausgleichsleitung durch Blitz- und/oder Fehlströme kommen kann.

Sich horizontal und/oder vertikal im Dachbereich überlappende Bahnen oder Bahnabschnitte sind vorzugsweise über wenigstens einen Stromableiter miteinander verbunden. Vorzugsweise ist es möglich, dass im Dachbereich verlegte Bahnen, die sich horizontal überlappen, über einen einzigen Stromableiter miteinander verbunden werden, der sich vom Dachfirst bis zur Dachtraufe des Daches erstrecken kann. Im vertikalen Überlappungsbereich zweier Bahnenden kann ein weiterer Stromableiter vorgesehen sein, um die Bahnenden miteinander elektrisch zu verbinden. Bedingt durch den relativ hohen ohmschen Widerstand im Überlappungsbereich benachbarter Bahnen oder Bahnabschnitte kommt es bei der Einkopplung von Blitz- und/oder Fehlströmen vor allem dort zu einer Beschädigung oder zum Zerstören der elektrisch leitenden Schicht der Bahn. Der Stromableiter weist vorzugsweise einen geringeren ohmschen Widerstand auf als die Bahn, zumindest als die Bahn im Überlappungsbereich. Steht die leitfähige Bahn aufgrund eines Blitzeinschlags oder eines Fehlers in der Elektroinstallation unter Spannung, wird daher der Strom im Wesentlichen über den Stromableiter und nicht über den Überlappungsbereich der Bahn abgeleitet. Dadurch sinkt die zum einen die Wärmeleistung, die im Überlappungsbereich erzeugt wird und zum anderen die Gefahr von Aussehmelzungen der elektrisch leitenden Schicht der Bahn.

Durch die Einbindung der leitfähigen Bahn in den Potentialausgleich des Gebäudes wird eine gezielte Stromableitung von Blitz- und/oder Fehlströmen zur Verfügung gestellt. Dadurch kann ausgeschlossen werden, dass die leitfähige Bahn im Falle eines Blitzeinschlags oder bei Fehlern in der Elektroinstallation unter Spannung steht. Durch die Erfindung kann es auch bei einem Blitzeinschlag oder bei Fehlern in der Elektroinstallation nicht zu einer Personengefährdung oder zur Entstehung von elektrischen Funken kommen. Blitzströme und/oder Fehlströme werden erfindungsgemäß über den Gebäudepotentialausgleich bzw. über einen Blitzschutzpotentialausgleich als Maßnahme des inneren Blitzschutzes in den Boden abgeleitet. Der Gebäudepotentialausgleich bzw. der Blitzschutzpotentialausgleich ist dabei derart ausgelegt, dass auch hohe Blitz- und/oder Fehlströme abgeleitet werden können, ohne dass es zu einer Zerstörung der geerdeten Potentialausgleichsleitung kommen kann. Die erfindungsgemäße Bahn ist dementsprechend derart mit einem Gebäudepotentialausgleich bzw. einer geerdeten Potentialausgleichsleitung verbindbar, dass Blitzströme und/oder Fehlströme über die Bahn und den Gebäudepotentialausgleich in den Boden ableitbar sind.

Durch die Verbindung der leitfähigen Bahn mit dem Gebäudepotentialausgleich kann darüber hinaus die baubiologische Wirksamkeit der Bahn im Zusammenhang mit der Abschirmung elektromagnetischer Strahlung verbessert werden. Im Fall ungeerdeter elektrisch leitfähiger miteinander verbundener Bahnen kann es nämlich dazu kommen, dass aufgrund elektrischer Feld-Emissionen von elektrischen Leitungen und Einrichtungen durch kapazitive Kopplung ein Ladungsungleichgewicht erzeugt wird, was dazu führen kann, dass die elektrisch leitende Schicht der Bahn selbst wie eine Antenne im Hzbis KHz-Bereich elektromagnetische Strahlung abstrahlt.

Im Falle eines Blitzeinschlags kommt es dazu, dass der Blitzstrom auf die leitfähige Bahn einkoppeln und an der Einkopplungsstelle sowie an den Übergängen zwischen benachbarten Bahnen und an den Anschlußelementen zu Ausschmelzungen in Verbindung mit elektrischem Funkenflug führen kann. Bedingt durch den hohen ohmschen Widerstand der Bahn finden Gleitüberschläge entlang der Oberfläche der Bahn statt. Durch die auftretenden Gleit-überschläge wird der in die Bahn eingekoppelte Blitzstrom deutlich reduziert; er ist allerdings immer noch so hoch, dass es zu einer Beschädigung, zum Teil sogar zur großflächigen Zerstörung der leitenden Schicht der Bahn kommen kann. Handelt es sich bei der leitfähigen Schicht der Bahn um eine Metallschicht, kann es dazu kommen, dass das Metall großflächig verdampft. Die Beschädigung oder Zerstörung der elektrisch leitenden Schicht führt dazu, dass sich die elektromagnetische Schirmwirkung der Bahn, abhängig vom Frequenzbereich, erheblich verschlechtern kann,

Um die direkte Blitzstromeinkopplung zu vermeiden, ist - wie bereits erwähnt - erfindungsgemäß vorgesehen, dass wenigstens ein mit wenigstens einer Bahn elektrisch leitend verbundener Stromableiter vorgesehen ist und dass der Stromableiter derart ausgebildet und mit der Bahn verbunden ist, dass Blitzströme und/oder Fehlströme zumindest über Bereiche der Bahn im Wesentlichen über den Stromableiter und nicht über die elektromagnetische

Schicht der Bahn zum Boden abgeleitet werden, so dass es beim Ableiten von Blitzströmen und/oder von Fehlströmen im Wesentlichen nicht zu einer Zerstörung der leitenden Schicht der Bahn kommen kann. Im Zusammenhang mit dem Ableiten von Fehlströmen können im elektrischen Fehlerfall kurzzeitig 50-Hz-Ströme mit einer Stromstärke von bis zu 16 A über die Bahn und die Anschluß- und Verbindungselemente fließen. Daher ist nicht auszuschließen, dass es auch im elektrischen Fehlerfall zu einer Beschädigung oder zu der Zerstörung der elektrisch leitenden Schicht der Bahn kommen kann.

Vorzugsweise wird durch den elektrischen Stromableiter sichergestellt, dass es überhaupt nicht zu einer direkten Einkopplung von Blitz- und/oder Fehlströmen in die Bahn kommen kann. Grundsätzlich ist es natürlich auch möglich, dass der Strom zwar in die Bahn zunächst einkoppelt, dann jedoch über den Stromableiter weiter- und abgeleitet wird. Dadurch können Schäden an der elektrisch leitenden Schicht der Bahn weitgehend minimiert werden.

Vorzugsweise ist wenigstens ein Stromableiter an den Gebäudepotentialausgleich direkt angeschlossen, so dass Blitzströme und/oder Fehlströme über den Stromableiter und den Grebäudepotentialausgleich direkt in den Boden abgeleitet werden können. Hierdurch wird eine Schädigung der Bahn an den Anschlußstellen weitgehend ausgeschlossen.

Der Stromableiter kann sich horizontal und/oder vertikal zum Überlappungsbereich und/oder über den Überlappungsbereich hinaus erstrecken. Der Abstand zwischen den Stromableitern sollte dabei möglichst so gewählt werden, dass das Einkoppeln von Blitzströmen und/oder von Fehlströmen in die Bahn möglichst ausgeschlossen wird. Sollte es dennoch zum Einkoppeln von Blitzströmen und/oder von Fehlströmen in die Bahn kommen, wird durch den Stromableiter zumindest sichergestellt, dass der Blitzstrom und/oder Fehlstrom im Wesentlichen über den Stromableiter abgeleitet wird und nicht über den Überlappungsbereich der Bahn. Dies dient wiederum dem Zweck, die bei der Stromableitung durch die Bahn freigesetzte Wärmeenergie möglichst weitgehend zu verringern, um eine Beschädigung der elektrisch leitenden Schicht der Bahn zu verhindern.

Der Stromableiter kann sich auf beiden Seiten des Überlappungsbereiches über eine Ausdehnung von 0,5 m bis 1,5 m, vorzugsweise von ca. 1,0 m, über den Überlappungsbereich hinaus erstrecken. Grundsätzlich ist es jedoch möglich, dass sich der Stromableiter vom Dachfirst bis zur Dachtraufe erstreckt und dass, vorzugsweise, auf jeder Dachfläche eines Dachbereiches lediglich ein Stromableiter vorgesehen ist. Es ist jedoch auch möglich, dass eine Mehrzahl von Stromableitern linienförmig und/oder netzartig elektrisch leitend miteinander verbunden werden. Damit wird eine ausreichend niederohmige Verbindung der benachbarten Bahnen oder Bahnabschnitte sichergestellt.

Als Stromableiter kann eine Beschichtung vorgesehen sein, vorzugsweise eine streifenförmige Folie, die auf zumindest einer Seite oder auch auf beiden Seiten eine Klebstoffschicht aufweisen kann. Der Stromableiter kann auch aus dem Bahnmaterial als solchem hergestellt sein. Beispielsweise ist es möglich, aus einer nicht verlegten Bahn ein vorzugsweise streifenförmiges Teilstück auszuschneiden und dieses als Stromableiter einzusetzen. Weist die verlegte Bahn auf der Außenseite eine elektrisch leitende Schicht auf, so kann der Stromableiter mit der elektrisch leitenden Seite auf die Bahn aufgeklebt werden. Vorzugsweise ist jedoch vorgesehen, dass der Stromableiter unter einer mit dem Dachbereich und/oder mit dem Fassadenbereich verbundenen Konterlattung verlegt wird. In diesem Zusammenhang kann auf die Konterlattung von unten eine flexible Zwischenlage aufgeklebt werden. Anschließend wird auf die Zwischenlage der Stromableiter mit der leitfähigen Seite nach außen aufgeklebt. Schließlich wird die Konterlattung mit der leitfähigen Außenseite auf die verlegte Bahn aufgesetzt und mit dem Dachbereich und/oder mit dem Fassadenbereich befestigt. Durch die Zwischenlage werden Unebenheiten des Untergrundes ausgeglichen und stets ein ausreichender elektrischer Kontakt sichergestellt. Ist die Bahn im Dachbereich verlegt, so erstreckt sich die Konterlattung vorzugsweise vom Dachfirst bis zur Dachtraufe, so dass alle auf einer Dachfläche des Dachbereiches verlegten Bahnen über den Stromableiter elektrisch miteinander verbunden sind. Die Konterlattung erstreckt sich jedoch zumindest über den Überlappungsbereich benachbarter Bahnen, wobei die Überlappungsstellen direkt unterhalb der Konterlattung angeordnet sein können.

Darüber hinaus ist es vorzugsweise vorgesehen, dass die Überlappungsbereiche derart mechanisch miteinander verbunden, vorzugsweise gefalzt sind, dass sich ein elektrischer Kontakt zwischen den elektrisch leitenden Schichten der überlappenden Bahnen oder Bahnabschnitte ergibt. Durch Falzen kann es beispielsweise möglich sein, einen ausreichenden elektrischen Kontakt zwischen den elektrisch leitenden Schichten der sich überlappenden Bahnen oder Bahnabschnitte zu gewährleisten, so dass es nicht notwendig ist, jeden Überlappungsbereich mit einem Stromableiter zu überbrükken.

Um die Ableitung von Blitzströmen und/oder Fehlströmen zu gewährleisten, kann jede Dachfläche des Dachbereiches, auf der eine Bahn verlegt ist, über wenigstens eine Potentialausgleichsleitung mit den Boden verbunden sein. Bei Dächern mit vielen kleinen Dachflächen, wie beispielsweise Erkern, Walmdächern über Eck oder dgl., können kleinere Dachflächen mit größeren Dachflächen direkt über eine Potentialausgleichsleitung verbunden werden, wobei lediglich die größeren Dachflächen über eine oder mehrere weitere Potentialausgleichsleitungen des Gebäudepotentialausgleichs mit dem Boden verbunden sein können.

Um eine sichere Stromableitung von Blitzströmen und/oder Fehlströmen über die Potentialausgleichsleitung zu gewährleisten, sollte die Potentialausgleichsleitung eine Querschnittsfläche von wenigstens 1,5 mm$^2$, vorzugsweise 2,5 mm$^2$, aufweisen, sofern die Potentialausgleichsleitung ummantelt ist. Die Ummantelung dient dem Schutz gegen mechanische Beschädigung, Nichtummantelte Potentialausgleichleitungen sollten eine Querschnittsfläche von wenigstens 3 mm$^2$, insbesondere von wenigstens 4 mm$^2$, aufweisen.

Zum elektrischen Anschluß der elektrisch leitenden Bahn an den Gebäudepotentialausgleich bzw. an eine Potentialausgleichsleitung des Gebäudes kann ein Anschlußelement vorgesehen sein, wobei das Anschlußelement vorzugsweise an den Stromableiter direkt angeschlossen wird. Beispielsweise ist es möglich, dass das Anschlusselement zwischen einer im Dachbereich und/oder im Fassadenbereich verlegten Bahn und einem Stromableiter eingespannt bzw. eingeklemmt wird, um eine elektrische Kontaktierung zwischen der Bahn, dem Stromableiter und der Potentialausgleichsleitung des Gebäudes sicherzustellen. Es ist grundsätzlich jedoch auch möglich, dass das Anschlusselement lediglich an die elektrisch leitende Schicht der Bahn angeschlossen wird. Beispielsweise kann als Anschlußelement ein Edelstahlblech mit einer Kontaktfläche von 100 cm$^2$ bis 200 cm$^2$, vorzugsweise von 120 cm$^2$ bis 150 cm$^2$, vorgesehen sein. In Zusammenhang mit der Erfindung ist festgestellt worden, dass auch bei einer wesentlich geringeren Kontaktfläche von 100 mm$^2$ bis 200 mm$^2$, vorzugsweise von 150 mm$^2$, bereits eine Kontaktierung sichergestellt sein kann. Grundsätzlich können auch andere Anschlußelemente, beispielsweise ein Aluminiumblech, eingesetzt werden. Als Schutzmaßnahme gegen elektrischen Schlag kann in der Elektroinstallation darüber hinaus der Einsatz eines Fehlerstromschutzschalters (FI) mit einem Auslösestrom von 20 mA bis 50 mA, vorzugsweise von ca. 30 mA, vorgesehen sein.

Um eine Grefährdung von Personen in jedem Fall ausschließen zu können, kann weiter vorgesehen sein, dass wenigstens ein mit der Bahn in Verbindung stehendes oder in dem Umgebungsbereich der Bahn angeordnetes elektrisch leitendes Teil und/oder eine elektrische Einrichtung mit der Bahn und/oder mit dem Stromableiter elektrisch leitend verbunden ist. Metallteile, die die leitfähige Bahn durchdringen, können an der Durchdringungsstelle mit der Bahn und/oder mit dem Stromableiter verbunden sein. Dies gilt z. B. für Antennenstandrohre, Metallkamine und -abgasrohre, Wasserleitungen zu Solarthermieanlagen, o. dgl. Als Anschlußelemente können hier an sich aus dem Stand der Technik bekannte Elemente eingesetzt werden. Metallgehäuse von elektrischen Einrichtungen, die außerhalb der leitfähigen Bahn angebracht sind, können zudem mit der leitfähigen Bahn und/oder dem Stromableiter verbunden werden. Dies kann der Einfachheit halber ebenfalls über eine oder mehrere Potentialausgleichsleitungen erfolgen, die mit der elektrischen Leitung zu der elektrischen Einrichtung mitgeführt und an der Durchdringungsstelle an die Bahn und/oder an den Stromableiter angeschlossen werden können. Als Anschlußelemente sind wiederum geprüfte, an sich aus dem Stand der Technik bekannte Elemente einsetzbar. Beispiele für elektrische Einrichtungen, die mit der leitfähigen Bahn verbunden werden können, sind Beleuchtungen, Satellitenantennen, Photovoltaikanlagen o. dgl. Werden metallene Teile und elektrische Leitungen, die die Bahn durchdringen, in Höhe der Durchdringungsstelle nicht mit der Bahn verbunden, wird auch die elektromagnetische Abschirmung frequenzabhängig beeinträchtigt. Metallgehäuse von elektrischen Einrichtungen, die direkt innerhalb des Dach- und/oder Fassadenbereiches an der leitfähigen Bahn angebracht sind, können ebenso mit der leitfähigen Bahn und/oder mit dem Stromableiter verbunden werden.

Die Elektroinstallation einer baulichen Anlage, in der die leitfähige Bahn verlegt werden soll, kann vorzugsweise in der Netzform TN-S aufgebaut sein. Dadurch kann beim Anschluß der Bahn an den Potentialausgleich des Gebäudes das Entstehen von vagabundierenden Strömen im Potentialausgleich verhindert werden. Bei der Netzform TN-S liegen getrennte Neutralleiter und Potentialausgleichsleiter vor. Damit wird der Potentialausgleichsleiter nicht durch betriebliche Ströme belastet.

Weist eine bauliche Anlage ein äußeres Blitzschutzsystem auf, so soll im Falle eines Blitzeinschlags der Blitzstrom durch das äußere Blitzschutzsystem, nämlich durch Fang- und Ableitungen, eingefangen, zum Erdungssystem abgeleitet und in den Boden eingeleitet werden. Um eine Einwirkung von Blitzströmen auf die leitfähige Bahn weitestgehend auszuschließen, kann erfindungsgemäß vorgesehen sein, dass der Trennungsabstand zwischen elektrisch leitfähigen Teilen der Blitzschutzeinrichtung, insbesondere von Fangleitungen und/oder Ableitungen, und der Bahn weniger als 50 cm, vorzugsweise zwischen IO cm und 30 cm, beträgt. Der Erfindung liegt an dieser Stelle der Gedanke zugrunde, dass die elektrisch leitfälüge Bahn derart von dem äußeren Blitzschutzsystem beabstandet verlegt wird, dass es nicht zum Einkoppeln von Blitzströmen auf die leitfähige Bahn kommen kann. Dadurch können Ausschmelzungen in Verbindung mit elektrischem Funkenflug verhindert werden. Hierbei ist zu beachten, dass es durch Ausschmelzungen der elektrisch leitenden Bahn wiederum zu einer Verschlechterung der elektromagnetischen Schirmwirkung der Bahn kommen kann. Eine direkte Blitzstromeinkopplung ist deshalb möglichst zu vermeiden.

Il einzelnen gibt es eine Vielzahl von Möglichkeiten, das erfindungsgemäße System auszugestalten und weiterzubilden, wobei einerseits auf die abhängigen Patentansprüche und andererseits auf die nachfolgende detaillierte Beschreibung bevorzugter Ausführungsbeispiele der Erfindung unter Bezugnahme auf die Zeichnung verwiesen wird. Im übrigen läßt es die Erfindung bedarfsweise zu, die in den Ansprüchen genannten und/oder die anhand der Zeichnung offenbarten und nachfolgend beschriebenen Merkmalen miteinander zu kombinieren, auch wenn dies nicht im einzelnen beschrieben ist. Die Erfindung ist darüber hinaus nicht auf die dargestellten und beschriebenen Ausführungsformen beschränkt.

In der Zeichnung zeigt

Fig. 1      eine schematische Teilschnittdarstellung eines Dachaufbaus eines Gebäudes,

Fig. 2    ein Gebäude mit einer im Dachbereich verlegten leitfähigen Bahn zur Abschirmung elektromagnetischer Strahlung und

Fig. 3    das in Fig. 2 dargestellte Gebäude mit einem äußeren Blitzschutzsystem.

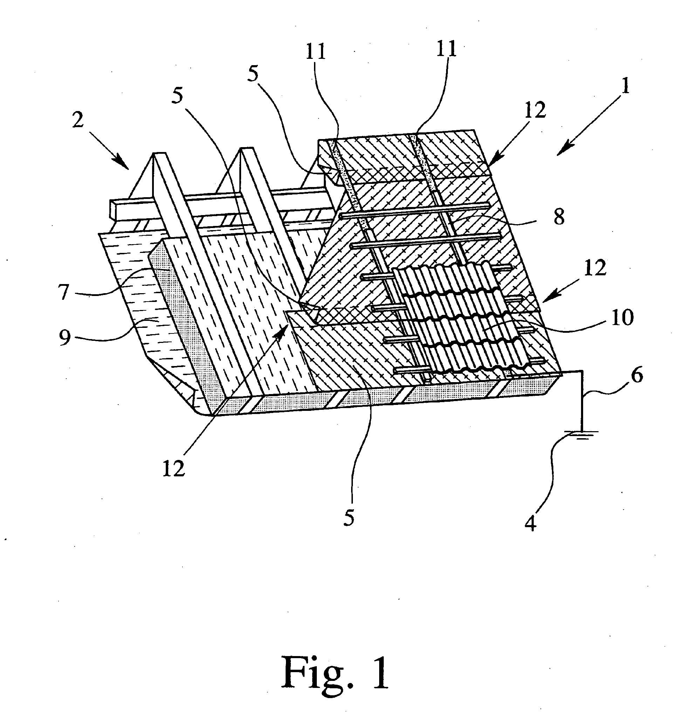

In Fig. 1 ist ein erfindungsgemäßes System 1 zum Ableiten von Blitzströmen und/oder von Fehlströmen aus einem Dachbereich 2 eines Gebäudes 3 in den Boden 4 schematisch dargestellt. Das System 1 weist im Dachbereich 2 eine leitfähige Unterspann- bzw. Unterdeckschalungsbahn 5 und wenigstens eine Potentialausgleichsleitung 6 eines Gebäudepotentialausgleichs auf. Die leitfähige Bahn 5 ist bei dem dargestellten Beispiel auf dem Dachgebälk oberhalb einer Isolierung 7 und unterhalb einer Konterlattung 8 vorgesehen. Unterhalb der Isolierung 7 ist im Inneren des Dachbereichs 2 eine Dampfsperre 9 vorgesehen. Auf der Konterlattung 8 kann eine Ziegeldeckung 10 vorgesehen sein, die in Fig. 1 lediglich schematisch dargestellt ist.

Die leitende Bahn 5 weist wenigstens eine elektrisch leitende Schicht auf der Außenseite zur Abschirmung elektromagnetischer Strahlung auf. Erfindungsgemäß ist zum Ableiten von Blitzströmen und/oder von Fehlströmen aus dem Dachbereich 2 des Gebäudes 3 vorgesehen, dass die Bahn 5 zur Erdung derart mit der Potentialausgleichsleitung 6 verbunden ist, dass Blitzströme und/oder Fehlströme über die Bahn 5 und die Potentialausgleichsleitung 6 in den Boden 4 ableitbar sind. Durch die Einbindung der leitfähigen Bahn 5 in den Potentialausgleich des Gebäudes 3 wird Blitzströmen und/oder Fehlströmen, die beispielsweise die Folge einer fehlerhaften Elektroinstallation sein können, eine gezielte Stromableitung zur Verfügung gestellt, so dass es weder im Falle eines Blitzeinschlags noch bei Fehlern in der Elektroinstallation dazu kommen kann, dass die leitfähigen Bahnen 5 unter Spannung stehen. Somit wird eine großflächige Personengefährdung im Dachbereich 2 und die Gefahr der Bildung von elektrischen Funken deutlich verringert. Der Erfindung liegt an dieser Stelle daher der Grundgedanke zugrunde, die Bahnen 5 als "fremde leitfähige Teile" zu behandeln und diese in den Gebäudepotentialausgleich einzubinden.

Die Bahnen 5 werden miteinander durch Stromableiter 11 elektrisch leitend verbunden, wobei sich die Stromableiter 11 von dem Dachfirst bis zur Dachtraufe erstrecken können. Grundsätzlich kann es für eine elektrische Kontaktierung der Bahnen 5 bereits ausreichen, einen Stromableiter 11 auf jeder Dachhälfte vorzusehen. Bei dem Stromableiter 11 kann es sich um leitfähige Folienstreifen oder um streifenförmige Teilstücke einer Bahn 5 handeln, die unterhalb der Konterlattung 8 verlegt werden. Hierzu ist es vorgesehen, dass zunächst eine flexible Unterlage von unten auf die Konterlattung 8 geklebt wird. Bei der flexiblen Unterlage kann es sich um ein Nageldichtungsband handeln. Auf die flexible Unterlage wird der Stromableiter 11 geklebt, wobei die elektrisch leitende Seite des Stromableiters 11 nach außen bzw. nach unten gerichtet ist. Anschließend wird die derart modifizierte Konterlattung 8 mit dem Dachbereich 2 befestigt, so dass die Bahnen 5 über den Stromableiter 11 elektrisch verbunden sind. Da es bei der direkten Einkopplung von Blitzströmen und/oder Fehlströmen in die Bahn 5 zu einer Beschädigung der elektrisch leitenden Schicht im Einkopplungsbereich und insbesondere an den Übergängen benachbarter Bahnen 5 kommen kann, werden die Bahnen 5 untereinander vorzugsweise horizontal und ggf. vertikal durch leitfähige Verbindungen zumindest im Überlappungsbereich miteinander verbunden. Aufgrund des geringeren elektrischen Widerstandes des Stromableiters 11 kommt es im Fall eines Blitzeinschlags oder beim Einkoppeln von Fehlströmen zu einer Ableitung der Ströme im Wesentlichen über den Stromableiter 11 und nicht über die Bahn 5. Dadurch können Schäden der leitenden Schicht der Bahn 5 weitgehend verhindert werden.

Wie aus Fig. 1 hervorgeht, ist wenigstens ein Stromableiter 11 mit der Potentialausgleichsleitung 6 verbunden und an den Gebäudepotentialausgleich angeschlossen. Dadurch wird die Ableitung von Blitzströmen und/oder Fehlströmen vom Dachbereich 2 in den Boden 4 gewährleistet. Beispielsweise kann im Bereich der Dachtraufe zwischen einer Bahn 5 und einem Stromableiter 11 bzw. der Konterlattung 8 ein Anschlußelement eingeklemmt sein, das an die Potentialausgleichsleitung 6 angeschlossen ist.

Da es insbesondere in den Überlappungsbereichen 12 benachbarter Bahnen 5 aufgrund des vergleichsweise hohen elektrischen Widerstandes in diesem Bereich bei der Ableitung von Blitzströmen und/oder Fehlströmen zu einer großflächigen Verdampfung des leitfähigen Materials der Bahn 5 kommen kann, sind die horizontalen Überlappungsbereiche 12 gemäß Fig. 1 über eine Mehrzahl sich vertikal erstreckender Stromableiter 11 miteinander elektrisch leitend verbunden. Vorzugsweise ist vorgesehen, dass sich die Stromableiter 11 auf beiden Seiten eines Überlappungsbereiches 12 zumindest über eine Ausdehnung von vorzugsweise ca. einem Meter über den Überlappungsbereich 12 hinaus erstrecken. Vorzugsweise ist eine Verbindung mehrerer benachbarter Bahnen durch einen Stromableiter 11 in einer Linie vorgesehen, wobei sich der Stromableiter 11 vom Dachfirst bis zur Dachtraufe über den Dachbereich 2 erstrecken kann. Dabei ist gemäß Fig. 1 eine Mehrzahl von Stromableitern 11 über die gesamte Länge des Dachbereiches 2 nebeneinander angeordnet. Durch die Stromableiter 11 wird eine ausreichend niederohmige Verbindung der Bahnen 5 gewährleistet.

Endet eine Bahn 5, kann vertikal eine leitende Verbindung zwischen einem Bahnanfang einer neuen Bahn 5 und einem Bahnende einer abgelaufenen Bahn 5 durch einen Stromableiter 11 sichergestellt werden. Der Stromableiter 11 kann mit Hilfe einer darüber angeordneten Konterlattung 8 fixiert werden, wobei die Überlappungsstelle direkt unterhalb der Konterlattung 8 angeordnet sein kann. Als Stromableiter 11 kann wiederum ein leitfähiger Folienstreifen oder ein streifenförmiges Teilstück einer Bahn 5 vorgesehen werden, um eine leitende Verbindung mit geringem Widerstand bereitzustellen. Das Bahnende und der Bahnanfang angrenzender Bahnen 5 können zudem überlappt und gefalzt werden, so dass ein elektrischer Kontakt der leitfähigen Schichten der Bahnen 5 bereits durch Falzen der Überlappungsbereiche gewährleistet sein kann. Im Ergebnis kann eine Mehrzahl von Stromableitern 11 linienförmig und/oder netzartig elektrisch leitend miteinander verbunden sein, um das Einkoppeln von Blitzströmen und/oder Fehlströmen möglichst auszuschließen, zumindest im Überlappungsbereich 12 benachbarter Bahnen 5.

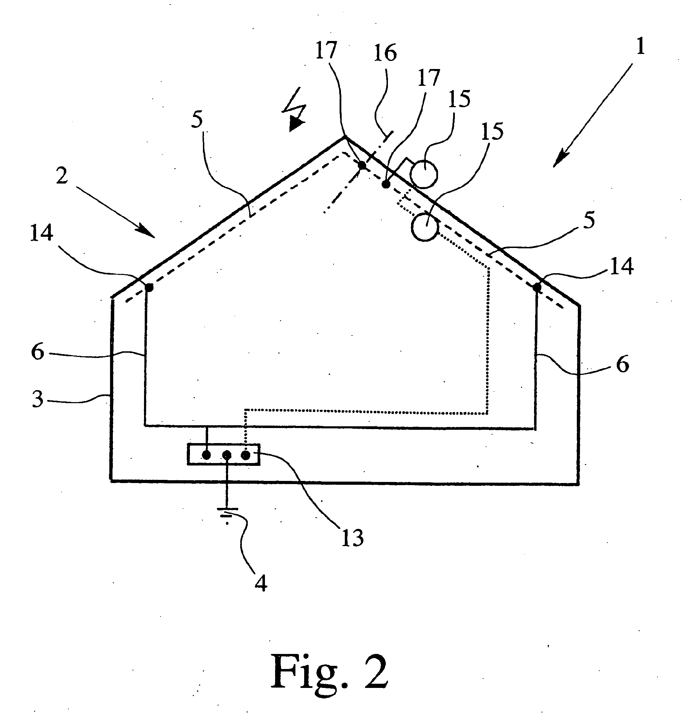

Gemäß Fig. 1 kann die Bahn 5 über den Stromableiter 11 mit der Potentialausgleichsleitung 6 verbunden sein. Dadurch wird eine Ableitung von Blitzströmen und/oder Fehlströmen in den Boden 4 gewährleistet. Bei der Potentialausgleichsleitung 6 handelt es sich um einen Teil des Potentialausgleichs des Gebäudes 3, was insbesondere in Fig. 2 dargestellt ist. Die Potentialausgleichsleitung 6 ist zu einer Potentialausgleichsschiene 13 geführt, welche mit dem Boden 4 verbunden ist.

Gemäß Fig. 2 ist jede Dachfläche des Dachbereiches 2 über wenigstens eine Potentialausgleichsleitung 6 mit der Potentialausgleichsschiene 13 verbunden. Damit ist jedes Dach über wenigstens zwei Potentialausgleichsleitungen 6 geerdet. Vorzugsweise sind die Potentialausgleichsleitungen 6 mit Hilfe der Konterlattung 8 mit wenigstens jeweils einem Stromableiter 11 auf jeder Dachfläche verbunden. Als Anschlußelement 14 kann ein Edelstahlblech mit einer Kontaktierungsfläche von ca. 120 cm$^2$ oder weniger vorgesehen sein. Innen- oder außenliegende elektrische Einrichtungen 15 und/oder leitfähige Teile 16, die die Bahn 5 bzw. die Dachdeckung durchdringen, sind vorzugsweise in Höhe der Durchdringungsstelle mit der leitfähigen Bahn 5 bzw. einem Stromableiter 11 über geeignete Anschlußelemente 17 verbunden.

Durch die genannten Maßnahmen wird sichergestellt, dass der Einsatz leitfähige Bahnen 5 im Dachbereich 2 und/oder im Fassadenbereich zu keinem erhöhten Schadensrisiko führt. Dies gilt sowohl für den Fall eines direkten Blitzeinschlags als auch für Fehler in der Elektroinstallation. Darüber hinaus ist das erfindungsgemäße System 1 auch im Zusammenhang mit Metalldächern, die als natürliche Bestandteile eines äußeren Blitzschutzsystems dienen können, einsetzbar.

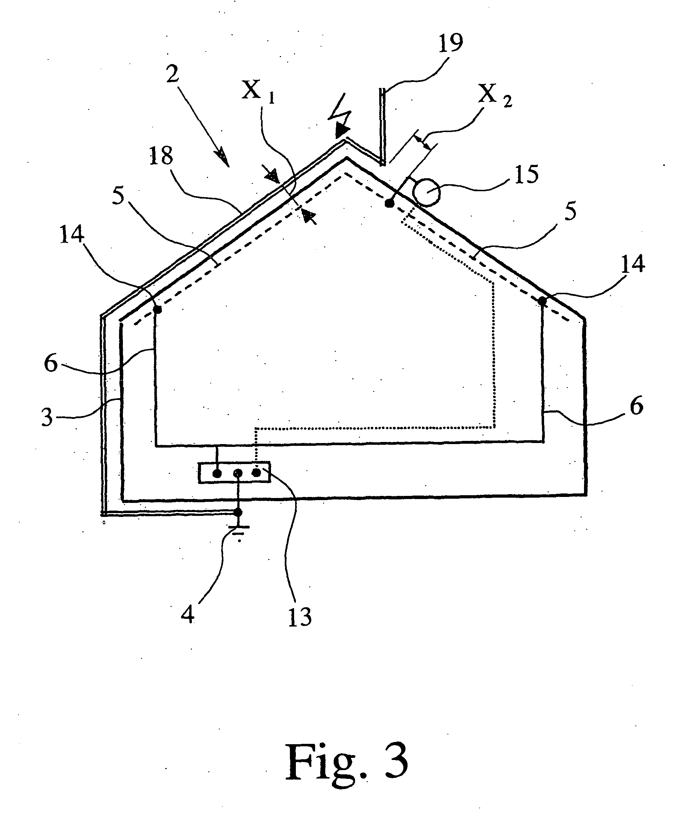

In Fig. 3 ist das in Fig. 2 dargestellte Gebäude 3 dargestellt, wobei das Gebäude 3 ein äußeres Blitzschutzsystem 18 aufweist. Das äußere Blitzschutzsystem 18 weist nicht im einzelnen dargestellte Fangeinrichtungen, Ableitungen und eine Erdungsanlage nach den gültigen Normen auf. Im Falle eines Blitzeinschlags soll Blitzstrom durch das äußere Blitzstromsystem 18 eingefangen, abgeleitet und in den Boden 4 eingeleitet werden. Um die Einwirkung von Blitzströmen auf die leitfähige Bahn 5 weitestgehend ausschließen zu können, ist vorgesehen, dass die Bahn 5 in einem Mindest-Trennungsabstand $X_1$ von nicht im einzelnen dargestellten Fangleitungen und Ableitungen des äußeren Blitzschutzsystems 18 beabstandet verlegt wird. Darüber hinaus müssen Fangleitungen und Ableitungen, beispielsweise eine Fangstange 19 des Blitzschutzsystems 18, die zum Schutz von Dachaufbauten, beispielsweise an einer Antenne, vorgesehen sein kann, in einem ausreichenden Trennungsabstand $X_2$ zu einer elektrischen Einrichtung 15 und/oder leitfähigen Teilen des Gebäudes 3 beabstandet sein. Zu den elektrischen Einrichtungen 15 können beispielsweise Dachantennen, Photovoltaik- und Solarthermieanlagen oder dgl. zählen.

Wird der Trennungsabstand zwischen Fangleitungen und Ableitungen des äu-βeren Blitzschutzsystems 18 und den Bahnen 5 eingehalten, kommt es zwar bei Blitzeinschlag durch den fließenden Blitzstrom in den unmittelbar darunterliegenden Bereichen der Bahn 5 bei einem Trennungsabstand in der Grö-βenordnung von wenigen 10 cm bis zu einigen 10 cm durch Kopplung zur Induzierung von Wirbelströmen. Diese weisen jedoch auch direkt unter einer vom Blitzstrom durchflossenen Leitung des Blitzschutzsystems 18 lediglich Maximalwerte von einigen 100 A bis zu wenigen kA auf. Darüber hinaus handelt es sich bei diesen Wirbelströmen um kurzzeitige Stromimpulse, die sehr schnell abklingen. Die Gefahr einer Beeinträchtigung der elektromagnetischen Schirmwirkung der Bahn 5 durch Beschädigung der elektrisch leitfähigen Schicht der Bahn 5 ist daher sehr gering.

Der Trennungsabstand $X_{1,2}$ kann aus nachfolgender Gleichung errechnet werden

$$X_{1,2} = k_i \bullet \frac{k_c}{k_m} \bullet L$$

mit den Parametern
$k_i$: Faktor zur Berücksichtigung der Blitzschutzklasse des Blitzschutzsystems 18,
$k_c$: Faktor zur Berücksichtigung der Geometrie des Blitzschutzsystems 18,
$k_m$: Faktor zur Berücksichtigung des Werkstoffs der elektrischen Isolation und
$L$: Abstand vom Ort des Potentialausgleichs bis zur Trennungsstelle.

Wird anstelle von Fangeinrichtungen ein Metalldach als natürliche Fangeinrichtung verwendet, ist es notwendig, den Trennungsabstand $X_{1,2}$ zwischen dem Metalldach und der Bahn 5 ebenfalls einzuhalten. Durch die genannten Maßnahmen wird sichergestellt, dass der Einsatz leitfähiger Bahnen 5 zu keinem erhöhten Personen- oder Schadensrisiko führen kann.

Nachfolgend werden zwei Ausführungsbeispiele der Erfindung beschrieben.

Ausführungsbeispiel 1:

Das erste Ausführungsbeispiel betrifft ein Einfamilienhaus mit einem Satteldach aus zwei Satteldachhälften, wobei das Satteldach eine Sparrenlänge von 8 m, eine Dachbreite von 14 m und einen Sparrenabstand von 0,5 m aufweist. Daraus ergibt sich eine Dachfläche jeder Satteldachhälfte von 112 m$^2$, Die Neigung des Daches beträgt 40°. Darüber hinaus wird das Dach durch einen Metallkamin und ein Antennenstandrohr durchdrungen. Das Dach ist mit Dachbetonsteinziegeln gedeckt und weist eine Vollsparrendämmung auf. Im Innenbereich ist eine Dampfbremse der Art DELTA-LUXX, die von der Anmelderin in der Praxis verwendet wird, eine Arbeitsebene und eine Gipskartonplattenverkleidung vorgesehen. Auf den Sparren ist eine diffusionsoffene Unterdeckbahn vorgesehen mit einem $S_d$-Wert von ca. 0,15 m. Die Unterdeckbahn weist eine äußere leitfähige korrosionsbeständige Beschichtung auf und ermöglicht einen Schutz gegen Strahlung im Niederfrequenzbereich von 20 dB bei 50 Hz, wobei für die baubiologische Wirksamkeit die Einbindung der Unterdeckbahn in einen Potentialausgleich notwendig ist. Die elektromagnetische Abschirmung durch die Unterdeckbahn beträgt 21 dB bei 1,9 GHz. Der Oberflächenwiderstand der Unterdeckbahn beträgt weniger als 4 $\Omega$/m$^2$, Die Breite der Unterdeckbahn beträgt 1,5 m, wobei die Länge der Unterdeckbahn 50 lfm/Rolle beträgt.

Innerhalb des Einfamilienhauses sind bauliche Anlagen vorgesehen, die nicht an ein äußeres Blitzschutzsystem angeschlossen sind. Erfindungsgemäß ist es vorgesehen, die leitfähigen Unterdeckbahnen in den Gebäudepotentialausgleich des Hauses einzubinden. Dazu ist es zunächst vorgesehen, die Unterdeckbahnen untereinander an horizontalen Überlappungsbereichen und/oder an vertikalen Überlappungsbereichen zu verbinden. Die horizontalen Überlappungsbereiche weisen eine Breite von 10 bis 15 cm auf, wobei auf jeder Satteldachfläche, d.h. auf jeder Seite des Daches, sechs Bahnen der Unterdeckbahn in horizontaler Richtung verlegt sind. Im Ergebnis müssen fünf horizontale Überlappungsbereiche miteinander verbunden werden, und zwar auf jeder Seite des Daches. Die Überlappungsbereiche werden gefalzt, wodurch eine elektrische Kontaktierung der überlappenden Bahnen erreicht wird.

Es ist vorgesehen, dass auf jeder Seite des Daches ein Stromableiter unter einer Konterlattung verlegt wird, um die verlegten Unterdeckbahnen zu verbinden. Der Stromableiter verläuft vorzugsweise vom Dachfirst bis zur Dachtraufe, so dass eine durchgehende elektrische Verbindung der Bahnen gewährleistet ist. Dazu wird eine flexible Unterlage der Art DELTA-NB 50 Nageldichtungsband, das von der Anmelderin in der Praxis verwendet wird, mit der Konterlattung verklebt. Auf das Dichtungsband wird ein Klebestreifen aus Aluminium geklebt, der eine Breite von 50 mm aufweist. Die metallische Seite ist nach außen gerichtet. Die derart modifizierte Konterlattung wird mit der metallischen Seite auf dem Dach befestigt, wobei der Stromableiter mit der Unterdeckbahn elektrisch kontaktiert wird. Anschließend wird die letzte Bahn über den First gezogen.

Im vorliegenden Ausführungsbeispiel ist auf jeder Seite des Daches ein vertikaler Überlappungsbereich zweier benachbarter Bahnenden vorgesehen. Die beiden Bahnenden werden auf einem Sparren überlappt und gefalzt, wobei es zu einer elektrischen Kontaktierung der überlappenden Bahnen kommt. Zusätzlich wird im vertikalen Überlappungsbereich eine modifizierte Konterlattung der vorbeschriebenen Art vorgesehen.

Der Übergangswiderstand im Bereich vertikaler und horizontaler Überlappungen beträgt weniger als 4 $\Omega$/m$^2$.

Abschließend wird die im Traufbereich vorgesehene Unterdeckbahn an eine Potentialausgleichsleitung (PAL) des Gebäudes mit einem Edelstahlblech angeschlossen, wobei das Edelstahlblech zwischen der Unterdeckbahn und der elektrisch leitfähigen Konterlattung eingespannt wird. Das Edelstahlblech weist eine Stärke von 0,3 mm, eine Länge von 240 mm und eine Breite von 80 mm auf. Die Kontaktfläche im Bereich der Konterlattung beträgt 120 cm$^2$, wobei die Kontaktfläche auch weitaus geringer sein kann. Auf jeder Seite des Daches ist eine Anschlußverbindung der im Traufbereich vorgesehenen leitfähigen Unterdeckbahn an die Potentialausgleichsleitung des Gebäudes vorgesehen. Bei einer ummantelten Potentialausgleichsleitung beträgt der Querschnitt der Leitung 2,5 mm, Die beiden Potentialausgleichsleitungen, nämlich jeweils eine Potentialausgleichsleitung auf jeder Seite des Daches, werden zur nächstliegenden Potentialausgleichsschiene (PAS) geführt und mit dieser verbunden. Die Elektroinstallation ist mit einem Fehlerstromschutzschalter (FI) mit einem Auslösestrom von 30 mA versehen. Zum Anschluß des Metalikamins und des Antennenstandrohrs ist es vorgesehen, auf der Höhe des Metallkamins bzw. des Antennenstandrohrs ein Edelstahlblech der vorbeschriebenen Art als Anschlußelement zwischen der Unterdeckbahn und dem Stromableiter bzw. der elektrisch leitfähigen Konterlattung zu verspannen und das Edelstahlblech über eine elektrische Leitung mit dem Metallkamin und/oder mit dem Antennenstandrohr zu verbinden.

Ausführungsbeispiel 2:

Das zweite Ausführungsbeispiel betrifft ein Mehrfamilienhaus mit einer Spitzgaube und einer Sattelgaube, wobei die Gesamtdachfläche ca. 450 m$^2$ und die Neigung des Daches ca. 40° beträgt. Das Dach des Hauses weist vier Satteldachflächen und eine Walmdachfläche auf. Die Spitzgaube ist im Bereich der Walmdachfläche und die Sattelgaube im Bereich der Satteldachfläche vorgesehen. Darüber hinaus ist eine Vollsparrendämmnung unter Schalung vorgesehen, wobei das Dach mit Tonziegeln gedeckt ist. Das Dach wird durch ein Antennenstandrohr und eine Photovoltaikanlage durchdrungen. Innerhalb des Daches ist eine Dampfsperre der Art DELTA-REFLEX sowie eine Arbeitsebene und eine Gipskartonplattenverkleidung vorgesehen. Auf der Schalung ist eine diffusionsoffene Schalungsbahn vorgesehen, die einen $S_d$-Wert von ca. 0,05 m aufweist. Die Schalungsbahn weist eine äußere leitfähige korrosionsbeständige Beschichtung auf. Durch Einbindung der Schalungsbahn in den Potentialausgleich des Gebäudes ist ein Schutz gegen Strahlung im Niederfrequenzbereich von 20 dB bei 50 Hz möglich. Die elektromagnetische Abschirmung der Schalungsbahn beträgt 21 dB bei 1,9 GHz, der Oberflächenwiderstand weniger als 4 $\Omega/m^2$. Die Bahn weist eine Breite von 1,5 m und eine Länge von 50 lfm/Rolle auf.

Im Haus sind bauliche Anlagen vorgesehen, die an ein äußeres Blitzschutzsystem angeschlossen sind. Die Elektroinstallation ist in der Netzform TN-S aufgebaut. Eine Einbindung der leitfähigen Schalungsbahn in den Potentialausgleich des Gebäudes ist erforderlich. Die auf dem Dach verlegten Bahnen sind untereinander an vertikalen und/oder horizontalen Überlappungsbereichen verbunden, wobei die horizontalen Überlappungsbereiche eine Breite von 10 cm bis 50 cm aufweisen. Jede Satteldachfläche weist einen Stromableiter auf, der unter einer Konterlattung verlegt ist. Dabei wird eine flexible Unterlage, beispielsweise der Art DELTA-NB 50 Nageldichtungsband, das von der Anmelderin in der Praxis vertrieben wird, auf die Unterseite der Konterlattung geklebt. Auf die flexible Unterlage wird ein Streifen der Schalungsbahn geklebt, der eine Breite von 50 mm aufweist. Die leitfähige Seite des auf die Konterlattung aufgeklebten Streifens ist nach außen gerichtet. Über die leitfähige Seite wird die Konterlattung mit den Schalungsbahnen des Daches verbunden und elektrisch kontaktiert, wobei die Konterlattung mit dem Dach befestigt wird. Wiederum verläuft der Stromableiter vorzugsweise vom Dachfirst bis zur Dachtraufe, so dass sich eine durchgehende elektrische Verbindung der Bahnen ergibt.

Darüber hinaus ist es vorgesehen, dass vertikale Überlappungsbereiche benachbarter Bahnen gefalzt werden. Durch das Falzen der sich überlappenden Bahnenden wird eine elektrische Kontaktierung im Überlappungsbereich sichergestellt. Anschließend wird eine modifizierte Konterlattung der zuvor beschriebenen Art im vertikalen Überlappungsbereich mit dem Dach verbunden.

Auf jeder Satteldachfläche wird die im Traufbereich verlegte leitfähige Schalungsbahn an eine Potentialausgleichsleitung (PAL) über ein Aluminiumblech mit einer Stärke von 0,4 mm angeschlossen. Das Aluminiumblech kann eine Länge von 200 mm und eine Breite von 50 mm aufweisen. Die Kontaktfläche unterhalb der Konterlattung kann ca. 100 $cm^2$ betragen. Die Kontaktierungsfläche kann jedoch weitaus kleiner sein.

Die auf den Dachflächen der Spitz- und Sattelgaube aufgebrachten Schalungsbahnen werden jeweils leitfähig miteinander und über vergleichsweise kurze Potentialausgleichsleitungen mit den größeren Dachflächen verbunden. Beispielsweise ist es möglich, eine Dachfläche der Spitzgaube mit der Walmdachfläche zu verbinden, während eine Dachfläche der Sattelgaube mit der die Sattelgaube aufweisenden Satteldachfläche verbunden wird. Darüber hinaus ist eine elektrische Potentialausgleichsleitung zwischen der Walmdachfläche und einer Satteldachfläche vorgesehen.

Die Potentialausgleichsleitung ist nicht ummantelt und weist einen Querschnitt von 4 mm auf. Die von den vier Satteldachflächen des Daches ausgehenden Potentialausgleichsleitungen werden zu der nächstgelegenen Potentialausgleichsschiene geführt und mit dieser verbunden. Die Elektroinstallation weist wiederum einen Fehlerstromschutzschalter (FI) mit einem Auslösestrom von 30 mA auf.

Zum Anschluß des Antennenstandrohrs und der Photovoltaikanlage ist es vorgesehen, ein Aluminiumblech der zuvor beschriebenen Art zwischen der Schalungsbahn und dem Stromableiter bzw. der modifizierten elektrisch leitfähigen Konterlattung auf der Höhe des Antennenstandrohrs und/oder der Photovoltaikanlage einzuspannen. Das Aluminiumblech wird über elektrische Leitungen mit dem Metallgehäuse der Photovoltaikanlage und/oder mit dem Antennenstandrohr verbunden, Darüber hinaus ist die Photovoltaikanlage durch das äußere Blitzschutzsystem geschützt, wobei weitere Fangeinrichtungen des äußeren Blitzschutzsystems vorgesehen sein können. Der Trennungsabstand zwischen den Fangeinrichtungen des äußeren Blitzschutzsystems und den metallenen bzw. elektrischen Einrichtungen, beispielsweise der leitfähigen Schalungsbahn, entspricht den Vorgaben gemäß DIN VDE 0100-540 und DIN EN 62305-3.

**Patentansprüche**

1.  System (1) zum Ableiten von Blitzströmen und/oder Fehlströmen aus einem Dachbereich (2) und/oder Fassadenbereich eines Gebäudes (3) in den Boden (4), mit wenigstens zwei Bahnen (5), wobei die Bahnen (5) mit wenigstens einer elektrisch leitenden Schicht zur Abschirmung elektromagnetischer Strahlung von einem Dachbereich (2) und/oder Fassadenbereich eines Gebäudes (3) versehen sind, wobei die elektrisch leitende Schicht zum Anschluß an einen Potentialausgleich ausgebildet ist, und wobei wenigstens ein mit den wenigstens zwei Bahnen (5) elektrisch leitend verbundener Stromableiter (11) vorgesehen ist, **dadurch gekennzeichnet, dass** überlappende Bahnen (5) vorgesehen sind, wobei der Stromableiter (11) einen geringeren ohmschen Widerstand aufweist als eine der Bahnen (5), zumindest eine der Bahne (5) im Überlappungsbereich, und dass der Stromableiter (11) derart ausgebildet und mit der Bahn (5) elektrisch verbunden ist, dass Blitzströme und/oder Fehlströme zumindest über Bereiche der Bahn (5) im Wesentlichen über den Stromableiter (11) und nicht über die elektrisch leitende Schicht der Bahn (5) über den Potentialausgleich zum Boden (4) abgeleitet werden, so dass es beim Ableiten von Blitzströmen und/oder Fehlströmen im wesentlichen nicht zu einer Zerstörung der leitenden Schicht der Bahn (5) kommt.

2. System nach Anspruch 1, **dadurch gekennzeichnet, dass** die Bahn (5) als Unterspannbahn, Unterdeckbahn, Schalungsbahn, Unterdeckschalungsbahn oder Fassendenbahn ausgebildet ist.

3. System nach Anspruch 1 oder 2, **dadurch gekennzeichnet, dass** die Bahnen (5) im Dachbereich und/oder im Fassadenbereich des Gebäudes (3) verlegt sind, wobei wenigstens ein Gebäudepotentialausgleich des Gebäudes (3) vorgesehen ist und wobei die Bahnen (5) unterhalb einer äußeren Deckung des Dachbereichs (2) und/oder des Fassadenbereichs vorgesehen sind.

4. System nach einem der vorhergehenden Ansprüche, **dadurch gekennzeichnet, dass** sich der Stromableiter (11) horizontal und/oder vertikal zu einem Überlappungsbereich (12) und/oder über den Überlappungsbereich (12) hinaus erstreckt.

5. System nach einem der vorhergehenden Ansprüche, **dadurch gekennzeichnet, dass** sich der Stromableiter (11) auf beiden Seiten des Überlappungsbereiches (12) über eine Ausdehnung von 0,5 m bis 1,5 m, vorzugsweise von ca. 1,0 m, über den Überlappungsbereich (12) hinaus erstreckt.

6. System nach einem der vorhergehenden Ansprüche, **dadurch gekennzeichnet, dass** sich der Stromableiter (11) vom Dachfirst bis zur Dachtraufe erstreckt und dass, vorzugsweise, auf jeder Dachfläche eines Dachbereiches (2) ein Stromableiter (11) vorgesehen ist.

7. System nach einem der vorhergehenden Ansprüche, **dadurch gekennzeichnet, dass** eine Mehrzahl von Stromableiter (11) vorzugsweise linienförmig und/oder netzartig elektrisch leitend miteinander verbunden ist.

8. System nach einem der vorhergehenden Ansprüche, **dadurch gekennzeichnet, dass** als Stromableiter (11) eine auf die Bahnen (5) aulklebbare leitende Beschichtung vorgesehen ist.

9. System nach einem der vorhergehenden Ansprüche, **dadurch gekennzeichnet, dass** die Bahnen (5) im Überlappungsbereich (12) derart mechanisch miteinander verbunden sind, vorzugsweise gefalzt sind, dass sich ein elektrischer Kontakt zwischen den elektrisch leitenden Schichten der Bahnen (5) ergibt.

10. System nach einem der vorhergehenden Ansprüche, **dadurch gekennzeichnet, dass** der Dachbereich (2) eine Mehrzahl von Dachflächen aufweist, auf denen die Bahnen (5) verlegt sind, und dass jede Dachfläche des Dachbereiches (2) über jeweils wenigstens eine Potentialausgleichsleitung (6) mit dem Boden (4) verbunden ist.

11. System nach einem der vorhergehenden Ansprüche, **dadurch gekennzeichnet, dass** wenigstens eine Dachfläche mit wenigstens einer weiteren Dachfläche über wenigstens eine Potentialausgleichsleitung (6) direkt verbunden ist und dass, vorzugsweise, lediglich die weitere Dachfläche über wenigstens eine weitere Potentialausgleichsleitung (6) mit dem Boden (4) verbunden ist,

12. System nach Anspruch 11 , **dadurch gekennzeichnet, dass** die Potentialausgleichsleitung (6) schutzummantelt ist und eine Querschnittsfläche von wenigstens 1,5 mm$^2$, vorzugsweise 2,5 mm$^2$, aufweiset oder dass die Potentialausgleichsleitung (6) nicht ummantelt ist und eine Querschnittsfläche von wenigstens 3 mm$^2$, insbesondere von wenigstens 4 mm$^2$, aufweist.

13. System nach einem der vorhergehenden Ansprüche 11 oder 12 **dadurch gekennzeichnet, dass** wenigstens ein Anschlußelement (14) zum elektrischen Verbinden der Potentialausgleichsleitung (6) mit den Bahnen (5) vorgesehen ist und dass, vorzugsweise, als Anschlußelement (14) ein Metallblech mit einer Kontaktfläche von 100 mm$^2$ bis 200 mm$^2$, insbesondere von 150 mm$^2$, vorgesehen ist.

14. System nach einem der vorhergehenden Ansprüche, **dadurch gekennzeichnet, dass** ein Fehlerstromschutzschalter vorgesehen ist und dass, vorzugsweise, der Fehlerstromschutzschalter ausgebildet ist für einen Auslösestrom von 20 mA bis 50 mA, vorzugsweise von ca. 30mA.

15. System nach einem der vorhergehenden Ansprüche, **dadurch gekennzeichnet, dass** wenigstens ein mit den Bahnen (5) in Verbindung stehendes oder in dem Umgebungsbereich der Bahnen (5) angeordnetes elektrisch leitendes Teil (16) und/oder eine elektrische Einrichtung (15) mit den Bahnen (5) und/oder mit dem Stromableiter (11) elektrisch leitend verbunden sind.

16. System nach einem der vorhergehenden Ansprüche, **dadurch gekennzeichnet, dass** die Elektroinstallation des Gebäudes (3) in der Netzform TN-S aufgebaut ist.

**17.** System nach einem der vorhergehenden Ansprüche, **dadurch gekennzeichnet, dass** eine äußere Blitzschutzeinrichtung (18) vorgesehen ist und dass der Trennungsabstand ($X_1$) zwischen elektrisch leitfähigen Teilen der Blitzschutzeinrichtung (18), insbesondere von Fangleitungen und/oder Ableitungen, und der Bahn (5) weniger als 50 cm, vorzugsweise zwischen 10 cm und 30 cm, beträgt.

**Claims**

**1.** System (1) for conducting away lightning currents and/or fault currents from a roof area (2) and/or façade area of a building (3) into the ground (4), with at least two webs (5), wherein the webs (5) are provided with at least one electrically conductive layer for the shielding of electromagnetic radiation from a roof area (2) and/or a façade area of a building (3), wherein the electrically conductive layer is designed for connection to a potential compensation system, and wherein at least one current arrester (11) connected in an electrically conductive manner with the at least two webs (5) is provided, **characterized in that** overlapping webs (5) are provided, wherein the current arrester (11) is provided with a lower ohmic resistance than one of the webs (5), at least one of the webs (5) in the overlapping area, and that the current arrester (11) is designed in such a manner and is with the web (5) electrically connected, that lightning currents and/or fault currents at least on areas of the web (5) are conducted away substantially via the current arrester (11) and not via the electrically conductive layer of the web (5) via the potential compensation system to the ground (4), so that substantially no destruction of the conductive layer of the web (5) occurs in the event of conducting away lightning currents and/or fault currents.

**2.** System as set forth in claim 1, **characterized in that** the web (5) is designed as reinforced formwork web, non-vapor-retardant sub-roof formwork web, non-vapor retardant formwork web, sub-roof formwork web or façade web.

**3.** System as set forth in claim 1 or 2, **characterized in that** the webs (5) are laid in the roof area and/or façade area of the building (3), wherein at least one building compensation system of the building (3) is provided and wherein the webs (5) are provided beneath an external cover of the roof area (2) and/or the façade area.

**4.** System as set forth in one of the foregoing claims, **characterized in that** the current arrester (11) extends horizontally and/or vertically to an overlapping area (12) and/or beyond the overlapping area (12).

**5.** System as set forth in one of the foregoing claims, **characterized in that** the current arrester (11) extends on both sides of the overlapping area (12) over an extension of 0.5 m to 1.5 m, preferably about 1.0 m, beyond the overlapping area (12).

**6.** System as set forth in one of the foregoing claims, **characterized in that** the current arrester (11) extends from the roof ridge to the roof gutter and that, preferably, a current arrester (11) is provided on every roof surface of a roof area (2).

**7.** System as set forth in one of the foregoing claims, **characterized in that** a plurality of current arresters (11) are connected in an electrically conductive manner to each other in a line and/or in the manner of a network.

**8.** System as set forth in one of the foregoing claims, **characterized in that** a conductive coating that can be adhered onto the webs (5) is provided as a current arrester (11).

**9.** System as set forth in one of the foregoing claims, **characterized in that** the webs (5) are mechanically connected to each other, preferably seamed, in the overlapping area (12) such that an electrical contact is produced between the electrically conductive layers of the webs (5).

**10.** System as set forth in one of the foregoing claims, **characterized in that** the roof area (2) has a plurality of roof surfaces on which the webs (5) are laid, and that each roof surface of the roof area (2) is connected to the ground (4) via at least one potential compensation conductor (6).

**11.** System as set forth in one of the foregoing claims, **characterized in that** at least one roof surface is directly connected to at least one further roof surface via at least one potential compensation conductor (6) and that, preferably, only the further roof surface is connected via at least one further potential compensation conductor (6) to the ground (4).

**12.** System as set forth in claim 11, **characterized in that** the potential compensation conductor (6) has a protective sheathing and a cross-sectional surface of at least 1.5 mm$^2$, preferably 2.5 mm$^2$, or that the potential compensation conductor (6) is not sheathed and has a cross-sectional surface of at least 3 mm$^2$, particularly of at least 4 mm$^2$.

**13.** System as set forth in claim 11 or 12, **characterized in that** at least one connection element (14) for electrically connecting the potential compensation conductor (6) to the webs (5) is provided and that, preferably, a metal plate with a contact surface of 100 mm² to 200 mm², particularly of 150 mm², is provided as connection element (14).

14. System as set forth in one of the foregoing claims, **characterized in that** a fault current protection breaker is provided and that, preferably, the fault current protection breaker is designed for a tripping current of 20 mA to 50 mA, preferably of about 30 mA.

15. System as set forth in one of the foregoing claims, **characterized in that** at least one electrically conductive part (16) and/or electrical device (15) connected to the webs (5) or arranged in the vicinity of the webs (5) is connected to the webs (5) and/or to the current arrester (11) in an electrically conductive manner.

16. System as set forth in one of the foregoing claims, **characterized in that** the electrical installation of the building (3) is constructed in the TN-S network configuration.

17. System as set forth in one of the foregoing claims, **characterized in that** an external lightning protection device (18) is provided and that the separation distance ($X_1$) between electrically conductive parts of the lightning protection device (18), particularly from lightning conductors and/or down-conductors, and the web (5) is less than 50 cm, preferably between 10 cm and 30 cm.

**Revendications**

1. Système (1) pour dériver les courants de foudre et/ou les courants de fuite à partir d'une zone de toit (2) et/ou d'une zone de façade d'un bâtiment (3) vers le sol (4), comportant au moins deux bandes (5), lesdites bandes (5) étant munies d'au moins une couche électroconductrice pour protéger une zone de toit (2) et/ou une zone de façade d'un bâtiment (3) contre un rayonnement électromagnétique, ladite couche électroconductrice étant réalisée pour le raccordement à une liaison équipotentielle, et il est prévu au moins un dérivateur de courant (11), relié par liaison électroconductrice auxdites au moins deux bandes (5), **caractérisé en ce que** des bandes (5) se chevauchant sont prévues, le dérivateur de courant (11) possédant une résistance ohmique plus faible que l'une des bandes (5), au moins une des bandes (5) dans la zone de chevauchement, et **en ce que** le dérivateur de courant (11) est configuré et est relié électriquement à la bande (5) de telle sorte que les courants de foudre et/ou les courants de fuite sont dérivés vers le sol (4) au moins via des zones de la bande (5), sensiblement par l'intermédiaire du dérivateur de courant (11), et non pas via la couche électroconductrice de la bande (5) par l'intermédiaire de la liaison équipotentielle, de telle sorte que lors de la dérivation des courants de foudre et/ou des courants de fuite, la couche conductrice de la bande (5) n'est sensiblement pas détériorée.

2. Système selon la revendication 1, **caractérisé en ce que** la bande (5) est réalisée sous la forme d'une sous-bande de serrage, d'une sous-bande de recouvrement, d'une bande de coffrage, d'une sous-bande de recouvrement de coffrage ou d'une bande de façade.

3. Système selon la revendication 1 ou 2, **caractérisé en ce que** les bandes (5) sont posées dans la zone de toit et/ou la zone de façade du bâtiment (3), au moins une bande (5) du bâtiment (3) étant prévue et les bandes (5) étant prévues en dessous d'une couverture extérieure de la zone de toit (2) et/ou de la zone de façade.

4. Système selon l'une quelconque des revendications précédentes, **caractérisé en ce que** le dérivateur de courant (11) s'étend horizontalement et/ou verticalement par rapport à une zone de chevauchement (12) et/ou au-delà de la zone de chevauchement (12).

5. Système selon l'une quelconque des revendications précédentes, **caractérisé en ce que** le dérivateur de courant (11) s'étend de part et d'autre de la zone de chevauchement (12) sur une dimension de 0,5 m à 1,5 m, de préférence sur environ 1,0 m, au-delà de la zone de chevauchement (12).

6. Système selon l'une quelconque des revendications précédentes, **caractérisé en ce que** le dérivateur de courant (11) s'étend depuis le faîte jusqu'au chéneau, et **en ce que**, de préférence, un dérivateur de courant (11) est prévu sur chaque surface d'une zone de toit (2).

7. Système selon l'une quelconque des revendications précédentes, **caractérisé en ce qu'**une pluralité de dérivateurs de courant (11) sont reliés de manière électroconductrice entre eux, de préférence en forme de lignes et/ou en forme de réseau.

8. Système selon l'une quelconque des revendications précédentes, **caractérisé en ce que** pour former le dérivateur de courant (11), il est prévu un revêtement conducteur pouvant être collé sur les bandes (5).

9. Système selon l'une quelconque des revendications précédentes, **caractérisé en ce que** les bandes (5) dans la zone de chevauchement (12) sont reliées mécaniquement entre elles, de préférence par sertissage, de telle sorte qu'il s'établit un contact électrique entre les couches électroconductrices des bandes (5).

10. Système selon l'une quelconque des revendications précédentes, **caractérisé en ce que** la zone de toit (2) comporte une pluralité de surfaces sur lesquelles sont posées les bandes (5), et **en ce que** chaque surface de la zone de toit (2) est reliée au sol (4) par l'intermédiaire de respectivement au moins une ligne de liaison équipotentielle (6).

11. Système selon l'une quelconque des revendications précédentes, **caractérisé en ce qu'**au moins une surface du toit est reliée directement à une autre surface du toit par l'intermédiaire d'au moins une ligne de liaison équipotentielle (6), et **en ce que**, de préférence, seulement l'autre surface du toit est reliée au sol (4) par l'intermédiaire d'au moins une autre ligne de liaison équipotentielle (6).

12. Système selon la revendication 11, **caractérisé en ce que** la ligne de liaison équipotentielle (6) est entourée d'une gaine de protection et possède une section transversale avec une surface d'au moins 1,5 mm$^2$, de préférence 2,5 mm$^2$, ou **en ce que** la ligne de liaison équipotentielle (6) n'est pas gainée et possède une section transversale avec une surface d'au moins 3 mm$^2$, en particulier d'au moins 4 mm$^2$.

13. Système selon la revendication 11 ou 12, **caractérisé en ce qu'**il est prévu au moins un élément de raccord (14) pour la liaison électrique de la ligne de liaison équipotentielle (6) avec les bandes (5), et **en ce que**, de préférence, il est prévu pour l'élément de raccord (14) une tôle métallique avec une surface de contact de 100 mm$^2$ à 200 mm$^2$, en particulier de 150 mm$^2$.

14. Système selon l'une quelconque des revendications précédentes, **caractérisé en ce qu'**il est prévu un disjoncteur de protection contre les courants de fuite et **en ce que**, de préférence, ledit disjoncteur de protection contre les courants de fuite est configuré pour un courant de déclenchement de 20 mA à 50 mA, de préférence de 30 mA environ.

15. Système selon l'une quelconque des revendications précédentes, **caractérisé en ce qu'**au moins un élément (16) électroconducteur, en liaison avec les bandes (5) ou disposé dans la zone environnante des bandes (5), et/ou un équipement électrique (15) sont reliés par une liaison électroconductrice avec les bandes (5) et/ou avec le dérivateur de courant (11).

16. Système selon l'une quelconque des revendications précédentes, **caractérisé en ce que** l'installation électrique du bâtiment (3) est configurée selon une forme de réseau TN-S.

17. Système selon l'une quelconque des revendications précédentes, **caractérisé en ce qu'**il est prévu un dispositif parafoudre (18) extérieur, et **en ce que** la distance de séparation ($X_1$) entre les éléments électroconducteurs du dispositif parafoudre (18), en particulier les lignes de protection et/ou les dérivations, et la bande (5) est inférieure à 50 cm, de préférence se situe entre 10 cm et 30 cm,

Fig. 1

Fig. 2

Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10337792 A1
- DE 20315042 U
- US 20030033755 A
- DE 1557383 A
- US 443048 A